(19) Europäisches Patentamt
European Patent Office
Office européen des brevets

(11) **EP 1 986 322 B1**

(12) **EUROPÄISCHE PATENTSCHRIFT**

(45) Veröffentlichungstag und Bekanntmachung des Hinweises auf die Patenterteilung:
**14.11.2012 Patentblatt 2012/46**

(51) Int Cl.:
*H03K 17/16* *(2006.01)*    *H02M 3/158* *(2006.01)*

(21) Anmeldenummer: **07008356.3**

(22) Anmeldetag: **24.04.2007**

(54) **Halbleiterschalter mit integrierter Verzögerungsschaltung**

Semiconductor switch with integrated delay circuit

Commutateur semi-conducteur avec circuit à retard intégré

(84) Benannte Vertragsstaaten:
**DE ES FR GB IT**

(43) Veröffentlichungstag der Anmeldung:
**29.10.2008 Patentblatt 2008/44**

(73) Patentinhaber: **Eberspächer Controls GmbH & Co. KG**
**76863 Herxheim (DE)**

(72) Erfinder:
• **Uhl, Günter, Dr.-Ing.**
**74921 Helmstadt-Bargen (DE)**
• **Wandres, Steffen**
**76870 Kandel (DE)**

(74) Vertreter: **Grünecker, Kinkeldey,**
**Stockmair & Schwanhäusser**
**Leopoldstrasse 4**
**80802 München (DE)**

(56) Entgegenhaltungen:
**EP-A1- 0 581 016     EP-A1- 1 172 923**
**JP-A- 2000 050 422     US-A1- 2005 073 288**
**US-A1- 2005 083 024     US-A1- 2005 237 040**

**Beschreibung**

Die vorliegende Erfindung bezieht sich auf einen Halbleiterschalter mit integrierter Verzögerungsschaltung, eine Steuereinheit zur pulsweitenmodulierten Ansteuerung einer mehrstufigen elektrischen Last sowie ein entsprechendes Verfahren.

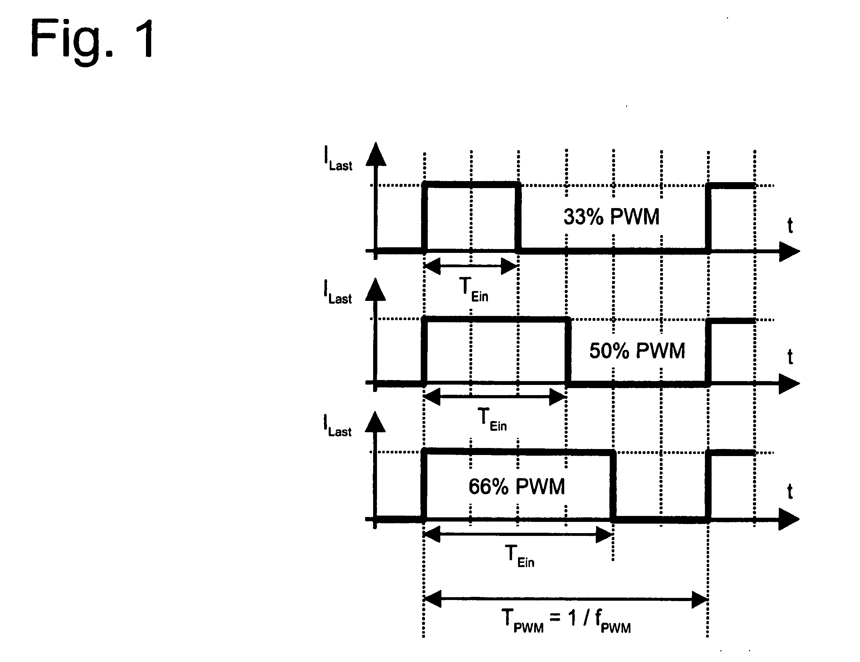

Die Steuerung der Strom- bzw. Leistungsaufnahme einer elektrischen Last, wie zum Beispiel elektrischer Heizungen, Glühlampen, Gleichstrommotoren, etc., kann herkömmlich über eine Pulsweitenmodulation (PWM) erfolgen. Die Versorgungsspannung wird dabei in periodischen Abständen ein- und ausgeschaltet. Über das Tastverhältnis, also das Verhältnis der Einschaltdauer $T_{Ein}$ innerhalb einer Periode zur Dauer $T_{PWM}$ der Periode (vgl. Fig. 1) kann die Leistungsaufnahme des Verbrauchers stufenlos gesteuert werden. Einschaltdauer $T_{Ein} = 0$ stellt den Zustand AUS dar, die Einschaltdauer $T_{Ein} = T_{PWM}$ bedeutet dauernd EIN, also maximaler Strom bzw. Leistung. Im Vergleich zu einer Linearregelung der Versorgungsspannung oder des Stroms, beispielsweise mittels eines Serientransistors, kann auf diese Weise die an den Transistoren der Endstufe auftretende Verlustleistung deutlich reduziert werden.

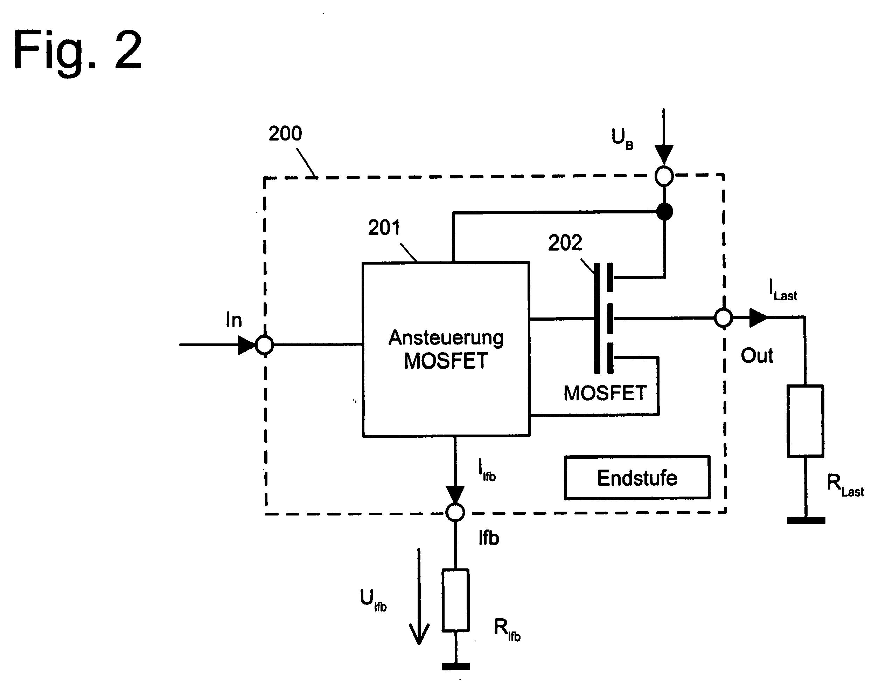

Als End- oder Schaltstufen einer PWM-Steuerung, d.h. als Halbleiterschalter für hohe Ströme, werden vorzugsweise MOSFETs eingesetzt, die entweder durch ihre äußere Zusatzbeschaltung angesteuert und gegen Überlastung (Überstrom, Überspannung und Übertemperatur) geschützt werden oder die diese erforderliche Zusatzbeschaltung bereits in ihrem Gehäuse beinhalten. Eine derartig geschützte Endstufe, oft auch als Smart-Power-Highside-Switch bezeichnet, wie sie beispielsweise von International Rectifier kommerziell erhältlich sind, ist in Fig. 2 dargestellt. Der interne Aufbau einer derartigen Endstufe 200 besteht aus zwei Halbleiter-Chips: dem eigentlichen Halbleiterschalter (MOSFET) 202 und einer Ansteuer- und Überwachungsschaltung 201. Die beiden Chips werden nebeneinander oder über einander angeordnet. Monolithische Lösungen (alle Funktionen auf einem Halbleiter-Chip) sind bei hohen Schaltströmen (mehrere 10 A) wenig verbreitet.

Nachteilig an einer PWM-Ansteuerung von Hochstromverbrauchern, insbesondere von Hochstromverbrauchern in einem Kfz-Bordnetz, wie z.B. einer elektrischen Zusatzheizung oder den Glühkerzen eines Dieselmotors, sind die durch die Taktung auftretenden Belastungsspitzen, die sich beispielsweise durch ein störendes Flimmern der Innenraumbeleuchtung bemerkbar machen können, sowie die generell mit den Schaltvorgängen verbundene EMV-Problematik (EMV: elektromagnetische Verträglichkeit).

Aus der Druckschrift JP 2000-050422 ist eine PWM-Motorsteuerung mit verbesserter EMV bekannt. Zur Steuerung der Drehrichtung des Motors ist eine Brückenschaltung aus vier Gruppen von FETs vorgesehen, wobei zur Erhöhung der Stromtragfähigkeit jede dieser Gruppen aus mindestens zwei parallel geschalteten FETs besteht. Zur Ansteuerung ist außerdem eine Steuereinrichtung vorgesehen, die einen PWM-Signalgenerator und eine Verzögerungseinrichtung umfasst. Auf diese Weise werden zwei PWM-Signale zur Verfügung gestellt, die um einen festen Betrag gegeneinander verzögert sind. Mit diesen PWM-Signalen werden die FETs der einzelnen Gruppen angesteuert, um so die durch die Schaltvorgänge verursachten EMV-Probleme zu reduzieren.

Aus der europäischen Patentschrift EP 1 157 869 B1 ist bekannt, eine mehrstufige elektrische Kfz-Zusatzheizung derart mittels einer Pulsweitenmodulation anzusteuern, dass jeweils nur eine der Heizstufen gleichzeitig mit einem Stromanstieg oder einem Stromabfall belegt wird.

Elektrische Zusatzheizungen werden in Kraftfahrzeugen beispielsweise zur Erwärmung der Innenraumluft, zur Vorheizung von Kühlwasser bei wassergekühlten Motoren oder zur Erwärmung von Kraftstoff verwendet. Derartige Zusatzheizungen bestehen üblicherweise aus zahlreichen, zu mehreren Heizstufen zusammengefassten Heizelementen und einer Steuervorrichtung. Die Heizelemente sind In der Regel als elektrischer Heizwiderstand, insbesondere als PTC-Element ausgebildet.

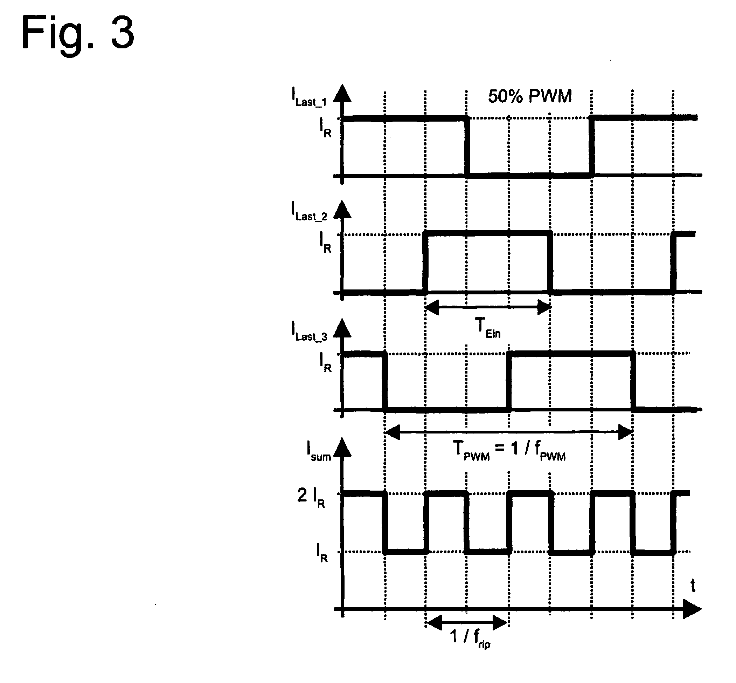

Eine besonders vorteilhafte PWM-Ansteuerung kann dadurch realisiert werden, dass die einzelnen Teillasten phasenversetzt angesteuert werden, um die Belastung des Kfz-Bordnetz durch periodische Stromschwankungen minimal zu halten. Wie in Fig. 3 exemplarisch für einen dreistufigen Verbraucher dargestellt ist, sind die drei getakteten Ströme $I_{Last\_1}$, $I_{Last\_2}$, $I_{Last-3}$ für jede Stufe um jeweils 1/3 der Periodendauer gegeneinander versetzt. Auf diese Weise kann die Gesamtlast $I_{sum} = I_{Last\_1} + I_{Last\_2} + I_{Last\_3}$ gleichmäßiger über die gesamte Periode verteilt werden. Wie in Fig. 3 ersichtlich ist, ist die Amplitude der periodischen Stromänderung (Ripple-Strom), mit der das Bordnetz belastet wird, nur ein Drittel (= 1 / n, n = Anzahl der Lastkreise) der Amplitude des Gesamtstroms, der sich durch Aufsummieren der drei Lastkreisströme ergibt. Wenn nicht phasenversetzt getaktet wird, sondern alle Laststufen gleichzeitig ein- und ausgeschaltet werden, würden im Bordnetz Stromschankungen zwischen Strom I=0 und dem maximalen Strom (dem Summenstrom aller Lastkreise) auftreten. Ein weiterer Vorteil der phasenversetzten Ansteuerung ist, wie man ebenfalls in Fig. 3 erkennt, dass sich die Frequenz des Ripple-Stromes verdreifacht hat ($f_{rip} = n * f_{PWM}$), ein Effekt, der in vielen Anwendungen wünschenswert ist. So kann dadurch beispielsweise die Frequenz des Flimmerns der Innenraumbeleuchtung auf einen nicht mehr wahrnehmbaren Frequenzbereich verschoben werden.

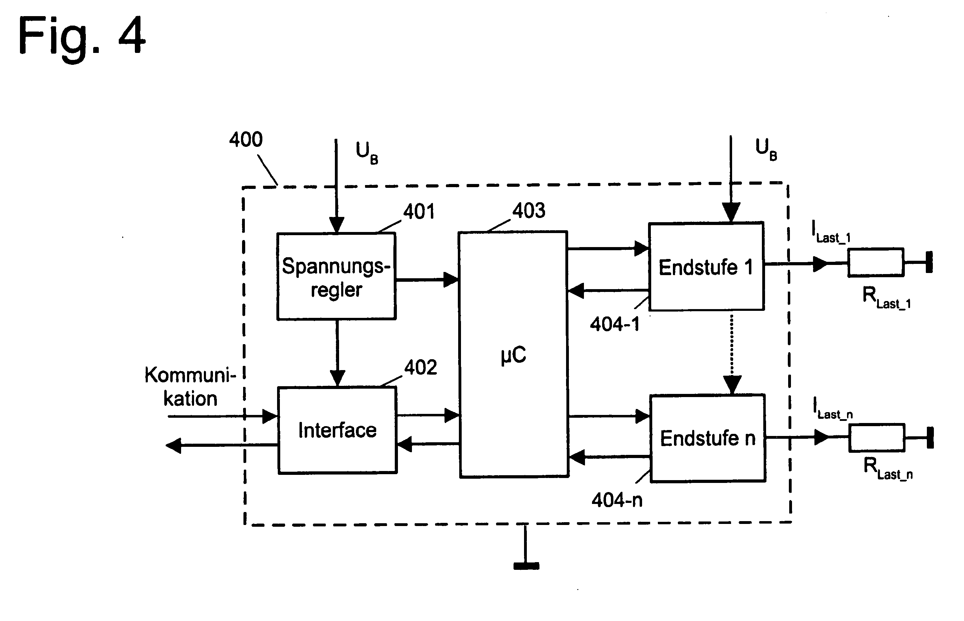

Figure 4 zeigt eine herkömmliche Steuervorrichtung 400, in der ein Mikrocontroller (µC) 403 eingesetzt wird, um die phasenversetzte Ansteuerung mehrerer Lastkreise $R_{Last\_1}$, ..., $R_{Last\_n}$ zu realisieren. Der Mikrocontroller 403 erzeugt dabei aus einer beliebigen Eingangsinformation, die über eine Schnittstelle (z.B. CAN-Bus) 402 zur Verfügung gestellt wird, die verschiedenen PWM-Signale und steuert die Endstufen 404-1, ..., 404-n entsprechend an. Im Falle einer Regelung der elektrischen Zusatzheizung kann die Eingangsinformation beispielsweise die Sollheizleistung und die im Bordnetz aktuell verfügbare elektrische Leistung umfassen.

Nachteilig an der Erzeugung der Signale zur phasenversetzten Ansteuerung mehrerer Lastkreise mittels eines Mikrocontrollers ist die vergleichsweise große Zahl erforderlicher Bauteile sowie die damit einhergehenden Kosten und der Platzbedarf. Zudem ist für den an sich schon kostspieligen Mikrocontroller die Entwicklung einer spezifischen Software erforderlich.

Eine besonders einfache Lösung zum phasenversetzten Ansteuern lässt sich für gewisse Anwendungen auch durch den Einsatz von analogen RC-Gliedern erreichen. Eine Voraussetzung hierbei ist, dass das Eingangssignal ein PWM-Signal ist, das in seiner zeitlichen Ausprägung (Periodendauer $T_{PWM}$ und Einschaltdauer $T_{Ein}$) direkt zur Ansteuerung der Lastkreise verwendet werden kann.

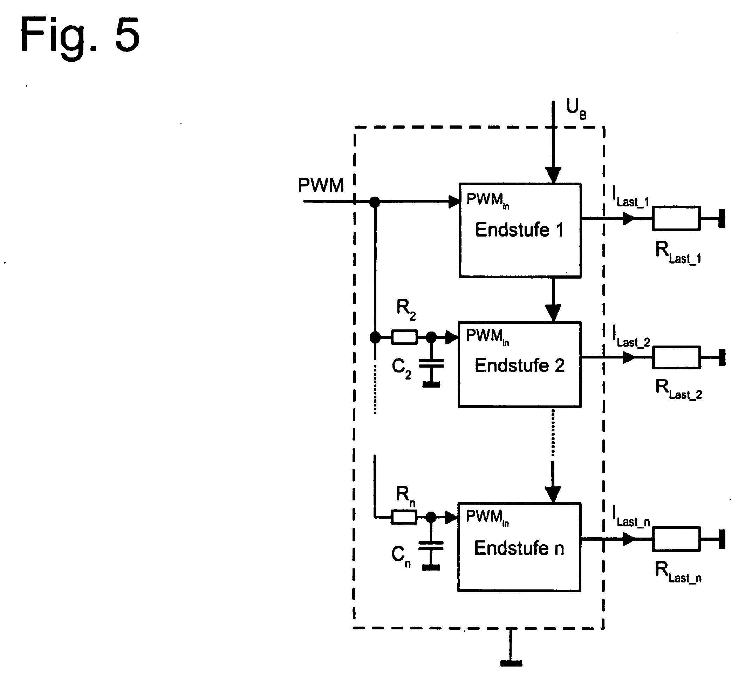

Figur 5 zeigt eine Schaltung zur Erzeugung der Signale zur phasenversetzten Ansteuerung mehrerer Lastkreise durch RC-Glieder. Das Ansteuersignal PWM wird dabei durch (n-1) RC-Glieder mit verschiedenen Zeitkonstanten $\tau_2$ bis $\tau_n$ zeitlich verzögern und den einzelnen Endstufen zugeführt. Für RC-Glieder ist die Zeitkonstante proportional zu dem Produkt R * C. Die jeweilige Verzögerungszeit $\tau_2$ bis $\tau_n$ wird durch die Periodendauer $T_{PWM}$ und die Anzahl n der Lastkreise bestimmt. In der Regel gilt für die einzelnen Verzögerungen bzw. RC-Glieder:

$$\tau_2 = T_{PWM} / n$$
$$\tau_3 = 2 * T_{PWM} / n$$
$$\tau_4 = 3 * T_{PWM} / n$$
$$...$$
$$\tau_n = (n - 1) * T_{PWM} / n$$

Nachteilig an der Verwendung analoger RC-Glieder zur Erzeugung der phasenversetzten PWM-Signale ist die hohe Zahl der erforderlichen diskreten Bausteine sowie die Anforderungen an deren Toleranzen. Die analoge Lösung mit RC-Gliedern stellt sehr hohe Anforderungen an die Genauigkeit der Bauteile der RC-Glieder (übliche Bauteile-Toleranzen liegen zwischen 5% und 10%, bei Kondensatoren auch noch darüber) und an die Präzision der Schaltung in der Endstufe, die das analoge Eingangssignal $PWM_{in}$ auswertet. Für diese Schaltung wird üblicherweise eine Schmitt-Trigger-Schaltung eingesetzt, die für die vorliegende Anwendung äußerst genaue und zeitlich stabile Schaltschwellen aufweisen muss. Ein weiterer Nachteile ist, dass die Verzögerungszeiten $\tau_2$ bis $\tau_n$ sehr genau auf die Periodendauer $T_{PWM}$ des PWM-Signals PWM abgestimmt sein müssen, um einen korrekten Phasenversatz der einzelnen Signale zu erreichen. Umgekehrt ergeben sich aus der Verkoppelung von Periodendauer und Verzögerungszeit entsprechende Anforderungen an das Steuergerät, das das PWM-Signal erzeugt. Die Frequenz des PWM-Signals muss auch dort sehr genau und stabil (ohne Drift) eingehalten werden. Derartige Forderungen an PWM-Signale sind aber nur mit entsprechend hohem Schaltungsaufwand zu realisieren. In einer PWM-Regelung wird zudem nicht die Frequenz des PWM-Signals ausgewertet, sondern nur das Tastverhältnis. Frequenzabweichungen sollten daher zulässig sein.

ZUSAMMENFASSUNG DER ERFINDUNG

Ziel der vorliegenden Erfindung ist es daher, eine verbesserte Schaltung zur Erzeugung der phasenversetzten PWM-Signale anzugeben. Ein weiteres Ziel der vorliegenden Erfindung ist es, einen integrierten Halbleiterschalter anzugeben, mit dem die Schaltung zur Erzeugung der phasenversetzten PWM-Signale kostengünstig realisiert werden kann. Außerdem ist es ein Ziel der vorliegende Erfindung, ein Steuergerät und ein entsprechendes Verfahren anzugeben, mit dem eine verbesserte PWM-Ansteuerung einer mehrstufigen elektrischen Last ermöglicht wird.

Dies wird durch die Merkmale der unabhängigen Ansprüche erreicht. Bevorzugte Ausführungsformen sind Gegenstand der abhängigen Ansprüche.

Es ist der besondere Ansatz der vorliegenden Erfindung, eine Endstufe zur PWM-Ansteuerung einer Laststufe mit einer Verzögerungsschaltung zu versehen, die zusätzlich zu dem durch ein PWM-Eingangssignal modulierten Laststrom ein PWM-Ausgangssignal liefert, das gegenüber dem PWM-Eingangssignal um einen vorgegebenen Bruchteil der Periodendauer verzögert ist.

Gemäß einem ersten Aspekt der vorliegenden Erfindung wird eine Endstufe mit den Merkmalen des unabhängigen Anspruchs 1 zur pulsweitenmodulierten Ansteuerung einer elektrischen Last zur Verfügung gestellt.

Erfindungsgemäß ist die Verzögerungsschaltung so eingerichtet, dass das zweite Pulsweitenmodulationssignal gegenüber dem ersten Pulsweitenmodulationssignal um Bruchteil der Periodendauer des ersten Pulsweitenmodulationssignals verzögert ist. Auf diese Weise können mehrere Stufen einer elektrischen Last in einfacher Weise mit PWM-Signalen angesteuert werden, die einen festen Zeit- oder Phasenversatz aufweisen. Vorzugsweise ist der Bruchteil der Periodendauer außerdem durch einen Stammbruch darstellbar. Durch eine Kaskadierung der Verzögerungsschaltungen können dann alle erforderlichen Phasenverschiebungen zur Ansteuerung einer mehrstufigen Last erzeugt werden.

Vorzugsweise besitzt die Endstufe nach Anspruch 1 einen zweiten Eingang zur Eingabe des Steuersignals. Damit kann der zeitliche Verschiebung der PWM-Signale auf die Anzahl der Stufen abgestimmt und extern vorgegeben werden.

Erfindungsgemäß umfasst die Verzögerungsschaltung eine erste Detektorschaltung, die die Periodendauer des ersten Pulsweitenmodulationssignals ermittelt, und das zweite Pulsweitenmodulationssignal so erzeugt, dass es gegenüber dem ersten Pulsweitenmodulationssignal um einen durch das Steuersignal bestimmten Bruchteil der ermittelten Periodendauer verzögert ist. Vorzugsweise ist die erste Detektorschaltung auch so eingerichtet, dass die Periodendauer während einer Periode des ersten Pulsweitenmodulationssignals ermittelt wird. Desweiteren umfasst die Verzögerungsschaltung vorzugsweise eine zweite Detektorschaltung, die die Einschaltdauer des ersten Pulsweitenmodulationssignals ermittelt, und das zweite Pulsweitenmodulationssignal so erzeugt, dass es die ermittelte Einschaltdauer aufweist. Vorteilhafterweise ist die zweite Detektorschaltung so eingerichtet, dass die Einschaltdauer während einer Periode des ersten Pulsweitenmodulationssignals ermittelt wird. Dadurch kann anstelle einer Verschiebungszeit direkt der Phasenversatz angegeben werden. Das verzögerte PWM-Signal wird dann automatisch mit den richtigen Timing-Parametem erzeugt. Probleme hinsichtlich der Genauigkeit der verwendeten Zeitbasis und/oder Schwankungen in der Eingangsfrequenz werden ebenfalls vermieden.

Vorzugsweise ist der Leistungshalbleiterschalter ein MOSFET (Metal Oxide Semiconductor Field Effect Transistor). Derartige Leistungshalbleiterschalter zeichnen sich durch ihre hervorragenden Fertigungs- und Schalteigenschaften aus.

Vorzugsweise ist der Leistungshalbleiterschalter und die Verzögerungsschaltung monolithisch auf einem Halbleiterchip integriert oder auf zwei getrennten Halbleiterchips realisiert, die in einem gemeinsamen Gehäuse integriert sind. Vorzugsweise ist die erfindungsgemäße Endstufe mit einer Zusatzschaltung zur Ansteuerung des Leistungshalbleiterschalters versehen. Die Ansteuerschaltung kann insbesondere eine Ladungspumpe umfassen, um eine Gate-Spannung zur Ansteuerung des MOSFETs zu erzeugen, die größer ist als die Betriebsspannung. Die Zusatzschaltung kann auch eine Schaltung zum Schutz des Leistungshalbleiterschalters vor Überlastung umfassen. Vorteilhafterweise sind die Verzögerungsschaltung und die Zusatzschaltung auch auf einem gemeinsamen Halbleiterchip integriert. Auf diese Weise lässt sich die erfindungsgemäße Endstufe leicht fertigen und flexibel einsetzen.

Gemäß einem zweiten Aspekt der vorliegenden Erfindung wird eine Steuereinheit zur pulsweitenmodulierten Ansteuerung einer elektrischen Last mit einer Mehrzahl elektrisch unabhängiger Laststufen zur Verfügung gestellt. Die Steuereinheit umfasst eine erste erfindungsgemäße Endstufe zur Ansteuerung einer ersten Laststufe der elektrischen Last gemäß einem vorgegebenen ersten Pulsweitenmodulationssignal und zur Ausgabe eines gegenüber dem ersten Pulsweitenmodulationssignal verzögerten zweiten Pulsweitenmodulationssignals und eine zweite Endstufe zur Ansteuerung einer zweiten Laststufe der elektrischen Last gemäß dem zweiten Pulsweitenmodulationssignal.

Vorzugsweise gehört die erste und die zweite Endstufe zu einer Mehrzahl kaskadiert verschalteter erfindungsgemäßer Endstufen, die jeweils einer Laststufe der elektrischen Last zugeordnet sind. Vorteilhafterweise gibt jede der kaskadiert verschalteten Endstufen ein Pulsweitenmodulationssignal aus, das gegenüber dem eingegebenen Pulsweitenmodulationssignal um einen Bruchteil der Periodendauer verschoben ist, der der Anzahl der Laststufen der elektrischen Last entspricht. Auf diese Weise kann eine mehrstufige Last mit phasenversetzten PWM-Signalen angesteuert werden, so dass die Strombelastung gleichmäßig über die PWM-Periodendauer verteilt ist. Lastspitzen werden so ebenso vermieden, wie eine gleichzeitige Schaltung mehrerer Laststufen.

Gemäß einem dritten Aspekt der vorliegenden Erfindung wird ein Verfahren zur pulsweitenmodulierten Ansteuerung einer elektrischen Last mit einer Mehrzahl elektrisch unabhängiger Stufen zur Verfügung gestellt. Das Verfahren umfasst die Schritte Kaskadieren einer Mehrzahl von erfindungsgemäßen Endstufen, wobei jede Endstufe eine Stufe der elektrischen Last ansteuert; Erzeugen eines Pulsweitenmodulationssignals; und Einspeisen des Pulsweitenmodulationssignals an der ersten Endstufe der kaskadierten Mehrzahl von Endstufen.

Die Erfindung wird im folgenden unter Bezugnahme auf die beigefügten Abbildungen beschrieben, in denen:

Fig. 1    eine schematische Darstellung der Pulsweitenmodulation zeigt,

Fig. 2    eine schematische Darstellung einer herkömmlichen Endstufe zeigt,

Fig. 3    eine schematische Darstellung der Signale zur phasenversetzten PWM-Ansteuerung einer mehrstufigen Last zeigt,

Fig. 4    schematisch eine herkömmliche Schaltung zur Erzeugung der phasenversetzten Signale durch einen Mikrocontroller darstellt,

Fig. 5    schematisch eine herkömmliche Schaltung zur Erzeugung der phasenversetzten Signale durch RC-Glieder darstellt,

Fig. 6A   schematisch den Aufbau einer PWM-Endstufe gemäß einer Ausführungsform der vorliegenden Erfindung darstellt,

Fig. 6B   schematisch den Aufbau der PWM-Verzögerungsschaltung der PWM-Endstufe aus Fig.

6A gemäß einer Ausführungsform der vorliegenden Erfindung darstellt,

Fig. 7    schematisch den Aufbau einer Steuereinheit zur pulsweitenmodulierten Ansteuerung einer mehrstufigen elektrischen Last gemäß einer Ausführungsform der vorliegenden Erfindung darstellt,

Fig. 8    die Erzeugung des verzögerten PWM-Signals durch die erfindungsgemäße PWM-Verzögerungsschaltung erläutert, und

Fig. 9    schematisch den Aufbau eines integrierten Halbleiterschalters gemäß einer weiteren Ausführungsform der vorliegenden Erfindung darstellt.

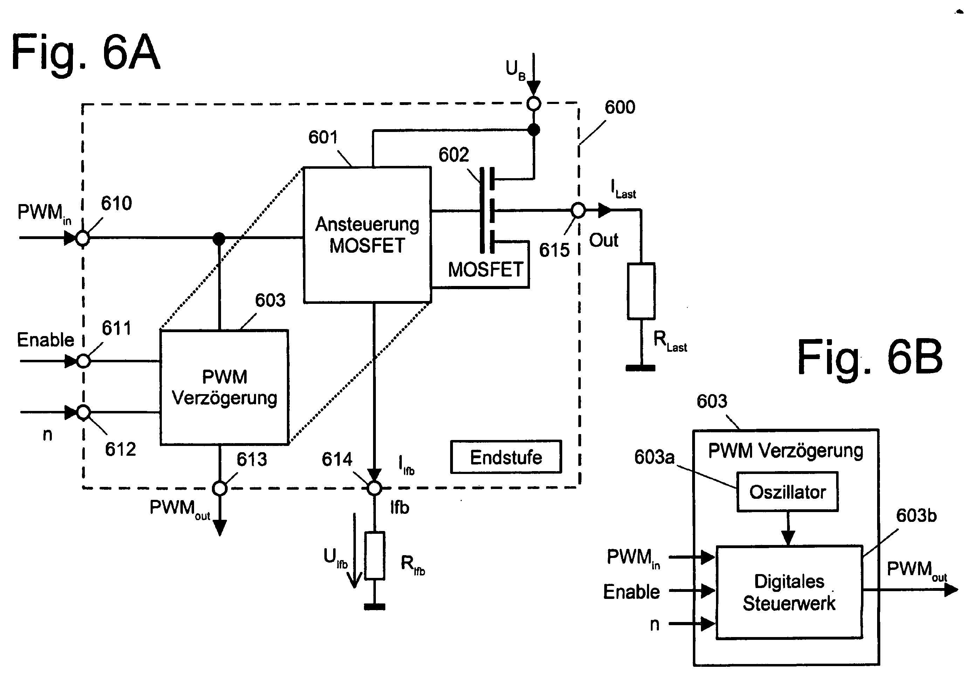

Figur 6A zeigt eine Endstufe zur PWM-Ansteuerung einer Last gemäß einer Ausführungsform der vorliegenden Erfindung. Über einen Leistungshalbleiterschalter 602, vorzugsweise einen MOSFET, ist die Last $R_{Last}$ mit der Versorgungsspannung $U_B$ verbunden. Der Laststrom $I_{Last}$ wird dabei durch die Ansteuerungsschaltung 601 nach Vorgabe des externen PWM-Signals PWM$_{in}$ moduliert. Die Ansteuerungsschaltung 601 kann zusätzliche Überwachungsfunktionen wahrnehmen und den Leistungshalbleiterschalter 602 vor Überlastung schützen. So kann die Ansteuerungsschaltung 601 beispielsweise die Temperatur des Leistungshalbleiterschalters 602 und/oder den geschalteten Strom überwachen. Im Falle einer Überschreitung vorgegebener Grenzwerte kann die Ansteuerungsschaltung den Halbleiterschalter abschalten. Außerdem kann ein Feedback-Signal $I_{lfb}$ als Maß für den durch einen Stromfühler erfassten Laststrom $I_{Last}$ an einem Anschluss Ifb für eine erweiterte externe Regelung zur Verfügung gestellt werden.

Die erfindungsgemäße Endstufe ist außerdem mit einer PWM-Verzögerungsschaltung 603 versehen, die ein gegenüber dem PWM-Eingangssignal PWM$_{in}$ verzögertes PWM-Signal PWM$_{out}$ erzeugt. Die Verzögerungsdauer $T_v$ bemisst sich dabei aus der Periodendauer $T_{PWM}$ des PWM-Eingangssignals PWM$_{in}$ und einem Steuersignal n:

$$T_V = T_{PWM} / n,$$

wobei n vorzugsweise eine ganze Zahl größer 1, insbesondere n=2, 3, 4, 5, 6 oder 8, darstellt. Das Verhältnis der Verzögerungsdauer $T_v$ zur Periodendauer $T_{PWM}$ ist somit durch einen Stammbruch (d. h. einen Bruch mit Zähler=1) darstellbar.

Das Steuersignal n wird dabei bevorzugt in digitaler Form extern vorgegeben, wobei unterschiedliche Ausgestaltungen des Steuersignalanschlusses möglich sind. Im einfachsten Falle besteht der Steuersignalanschluss aus einer oder mehreren digitalen Signalleitung(en), an denen das Teilverhältnis n über entsprechende digitale Signalpegel angelegt wird. Alternativ kann aber auch jede andere parallele oder serielle Schnittstelle verwendet werden.

Das Steuersignal n kann aber auch innerhalb der Endstufe erzeugt werden, insbesondere wenn die Endstufe als integrierter Baustein realisiert wird. Der Wert des Steuersignals n kann dabei durch eine Programmierung bei der Herstellung des Bausteines (z.B. Zener-Zapping) oder durch geeignete unterschiedliche Bondverbindungen zwischen den externen Anschlüssen und dem Silizium-Chip vorgegeben werden.

Die Endstufe kann außerdem mit einem "Enable"-Eingang versehen sein, an den ein digitales Enable-Signal angelegt wird. Mit dem Eingangssignal Enable wird die Funktion des Blockes "PWM-Verzögerung" 603 aktiviert bzw. deaktiviert. Die Enable-Funktion kann auch als Zu- bzw. Wegschalten der Versorgungsspannung $U_B$ für die Schaltungsblöcke "Ansteuerung MOSFET" 601 und "PWM-Verzögerung" 603 realisiert werden.

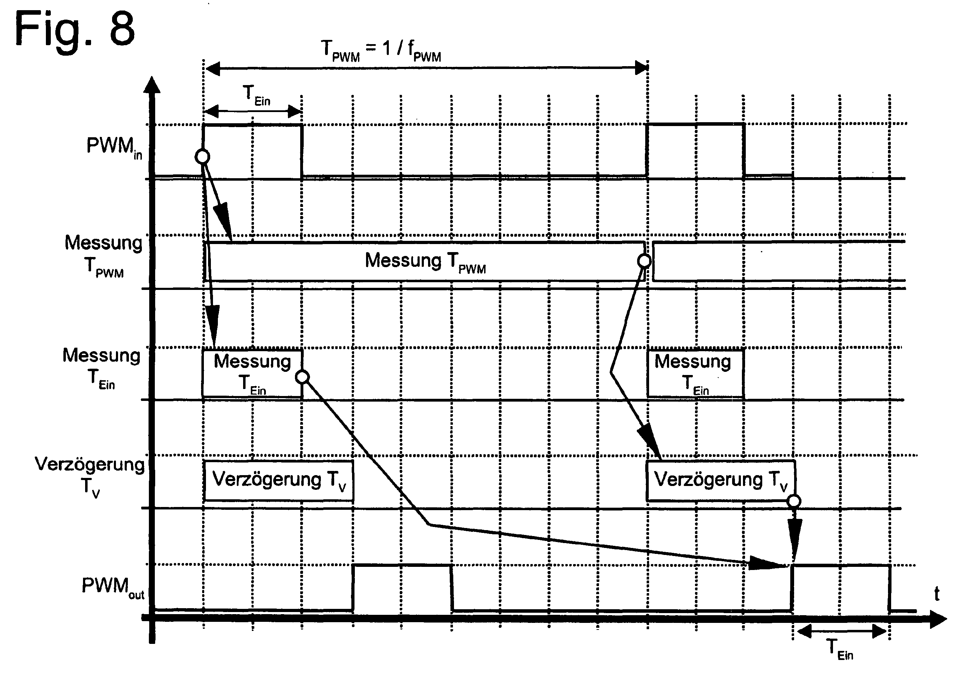

Figur 6B zeigt den Aufbau der PWM-Verzögerungsschaltung 603 gemäß einer Ausführungsform der vorliegenden Erfindung. Die Eingangssignale PWM$_{in}$, Enable und n gelangen an ein digitales Steuerwerk 603b, das das Ausgangssignal PWM$_{out}$ erzeugt und ausgibt. Die PWM-Verzögerungsschaltung 603 umfasst des weiteren ein internen Oszillator 603a, der dem digitalen Steuerwerk 603b ein Taktsignal zur Verfügung stellt. Die Funktion des Steuerwerks wird weiter unten im Zusammenhang mit Fig. 8 genauer beschrieben.

Die in Figur 6A und 6B gezeigte erfindungsgemäße Endstufe 600 wird vorzugsweise als integrierte Schaltung realisiert. Insbesondere kann die erfindungsgemäße Endstufe realisiert werden, indem die in der in Fig. 2 gezeigten herkömmlichen Endstufe 200 ohnehin enthaltene Ansteuer- und Überwachungsschaltung 201 um einen zusätzlichen Schaltungsblock "PWM-Verzögerung" erweitert wird. Vorzugsweise wird man diesen Schaltungsblock auch in dem Gehäuse der Endstufe unterbringen und vorzugsweise auch zusammen mit dem Block "Ansteuerung MOSFET" 601 auf einem gemeinsamen Halbleiter-Chip unterbringen (vgl. die gestrichelten Linien in Fig. 6). Auf diese Weise kann die erfindungsgemäße Endstufe in besonders effizienter Weise gefertigt werden.

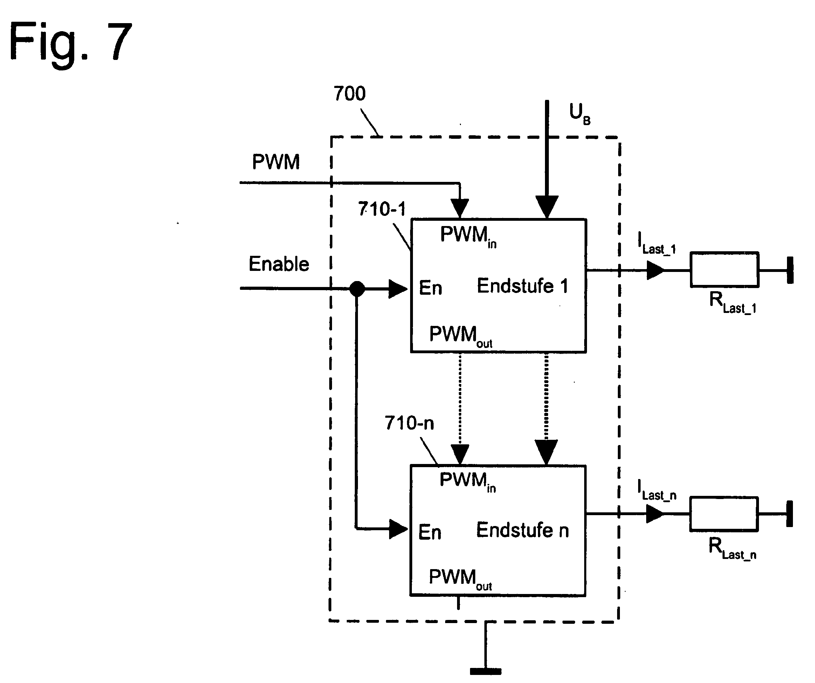

Figur 7 zeigt eine Steuereinheit gemäß einer Ausführungsform der vorliegenden Erfindung zur Ansteuerung einer mehrstufigen Last. Die Steuereinheit 700 steuert n Lastkreise $R_{Last\_1}$, ..., $R_{Last\_n}$ mit pulsweitenmodulierten Lastströmen $I_{Last\_1}$, ..., $I_{Last\_n}$ an, die jeweils um den Betrag $T_v = T_{PWM} / n$ zeitlich gegeneinander verzögert sind. Die Steuereinheit 700 besteht im Wesentlichen aus n erfindungsgemäßen Endstufen 710-1, ..., 710-n, wie sie oben im Zusammenhang mit Fig. 6 beschrieben wurden. Die einzelnen Endstufen 710-1, ..., 710-n sind dabei sequentiell verschaltet (kaskadiert), so dass das von einer Endstufe ausgegebene verzögerte PWM-Signal das Eingangssignal für die jeweils nächste Endstufe bildet. Auf diese Weise muss lediglich ein einziges PWM-Signal extern generiert werden; die Mehrzahl der verzögerten PWM-Signale wird von den kaskadierten Endstufen selbst erzeugt. Damit reduziert sich die Anzahl der Bauteile für die Steuereinheit zum Ansteuern von n Lastkreisen im Vergleich zum Stand der Technik, siehe Fig. 4, auf n Endstufen mit erfindungsgemäß erweiterter Funktionalität.

Neben dem externen PWM-Signal kann die Steuereinheit optional mit einem Enable-Signal versorgt werden, das an alle Endstufen der Steuereinheit gleichermaßen angelegt wird. Das (in Fig. 7 nicht dargestellte) Steuersignal n, das den Betrag der Verzögerung relativ zur Periodendauer des PWM-Signals festlegt, ist ebenfalls für alle Endstufen gleich und kann in der Steuereinheit selbst generiert werden, indem beispielsweise die zugehörigen Digitaleingänge der Endstufen auf die entsprechenden Logikpegel gesetzt werden.

In der Steuereinheit aus Fig. 7 ist der PWM-Signalausgang der letzten Endstufe 710-n offen, da zur Ansteuerung von n Laststufen nur (n-1) Verzögerungsschaltungen erforderlich sind. Die letzte Endstufe 710-n kann daher auch durch eine herkömmliche Endstufe ohne Verzögerungsschaltung, wie sie in Fig. 2 dargestellt ist, ersetzt werden.

Figur 8 ist ein Diagramm, anhand dessen im folgenden die Funktionsweise des digitalen Steuerwerks 603b aus Fig. 6B erläutert wird.

Innerhalb jeder PWM-Periode $T_{PWM}$ wird einerseits das PWM-Eingangssignal $PWM_{in}$ vermessen und andererseits das PWM-Ausgangssignal gemäß der Ergebnisse der Vermessung aus der vorhergehenden Periode generiert. Im einzelnen werden die folgenden Schritte durch das Steuerwerk durchgeführt:

(1) Vermessen des PWM-Eingangssignals $PWM_{in}$ (mit der Periodendauer $T_{PWM}$ und der Einschaltdauer $T_{Ein}$ ) hinsichtlich $T_{PWM}$ und $T_{Ein}$ und speichern der Werte,

(2) Ermitteln der vom Steuersignal n, bzw. von der Anzahl n der Lastkreise abhängigen Verzögerungszeit $T_v$, mit der das PWM-Eingangssignal am Ausgang $PWM_{out}$ ausgegeben werden soll: $T_v = T_{PWM} / n$,

(3) nach Ablauf eines Taktzyklus $T_{PWM}$ des Signals $PWM_{in}$ Start der Verzögerungszeit $T_v$, und

(4) nach Ablauf der Verzögerungszeit $T_v$ Aktivierung des Ausgangssignals $PWM_{out}$ für die Zeit $T_{Ein}$.

Das digitale Steuerwerk 603b kann durch eine geeignete Verschaltung herkömmlicher Logikgatter realisiert werden. Die Periodendauer $T_{PWM}$ und die Einschaltdauer $T_{Ein}$ können beispielsweise mit Hilfe von einem durch den Oszillator 603a getriebenen Binärzähler ermittelt werden und in einem Auffangregister gespeichert werden. Vorzugsweise besitzt das Steuerwerk ein weiteres Register, in dem die auf Basis der ermittelten Periodendauer und des Steuersignals n berechnete Verzögerung $T_v$ gespeichert wird. Das Ausgangssignal $PWM_{out}$ kann ebenfalls mittels eines durch den Oszillator getriebenen Binärzählers und eines Komparators, der den Zählerstand mit den gespeicherten Registerwerten vergleicht, erzeugt werden.

Sowohl die Vermessung des Eingangssignals $PWM_{in}$, als auch die Erzeugung des Ausgangssignals $PWM_{out}$ erfolgt relativ zu dem von dem Oszillator 603a erzeugten Taktsignal. Auf diese Weise werden die Probleme hinsichtlich der Genauigkeit und der Stabilität der Zeitbasis in herkömmlichen Steuereinheiten zur phasenversetzten Ansteuerung mehrerer Lastkreise gelöst. Insbesondere ist keine Eichung der Zeitbasis (beispielsweise in Millisekunden oder dergleichen) erforderlich, da der genaue Wert der Taktfrequenz des Oszillators 603a keine Rolle für die Erzeugung des Ausgangssignals spielt. Allenfalls die Granularität in der Bestimmung der Verzögerungsdauer $T_v$ und der Einschaltdauer $T_{Ein}$ hängt von der Wahl der Taktfrequenz ab. In der Praxis werden PWM-Signale mit einer Frequenz von einigen 10Hz bis 1 kHz verwendet, so dass Taktfrequenzen von 10kHz-1 MHz für eine ausreichende zeitliche Auflösung hinreichend sind.

Zum anderen wird die Vermessung des Eingangssignals in jeder PWM-Periode wiederholt. Aus diesem Grund sind keine Vorkehrungen zur Stabilisierung der Oszillatorfrequenz gegen (thermische) Drift erforderlich, da driftbedingte Änderungen der Oszillatorfrequenz auf einer Zeitskala auftreten, die deutlich langsamer ist, als die Periodendauer der Pulsweitenmodulation.

Schließlich erübrigt sich auch die Abstimmung der Verzögerungszeit auf die Periodendauer der Pulsweitenmodulation, da die erfindungsgemäße Endstufe als Eingabeinformation lediglich die Anzahl der phasenversetzt anzusteuernden Stufen benötigt und daraus die erforderliche Verzögerungszeit in Abhängigkeit von der gemessenen Periodendauer selbst berechnet. Auf diese Weise kann die erfindungsgemäße Steuereinheit sogar auf Variationen in der Frequenz des externen PWM-Signals reagieren.

In den oben beschriebenen Ausführungsformen der erfindungsgemäßen PWM-Endstufe wird ein digitales Schaltwerk zur Erzeugung des verzögerten PWM-Signals $PWM_{out}$ verwendet. Die vorliegende Erfindung ist aber nicht auf eine digitale Erzeugung des verzögerten PWM-Signals $PWM_{out}$ beschränkt. Vielmehr kann auch eine analoge Schaltung, beispielsweise mit einem PLL (phase locked loop: Phasenregelkreis) verwendet werden.

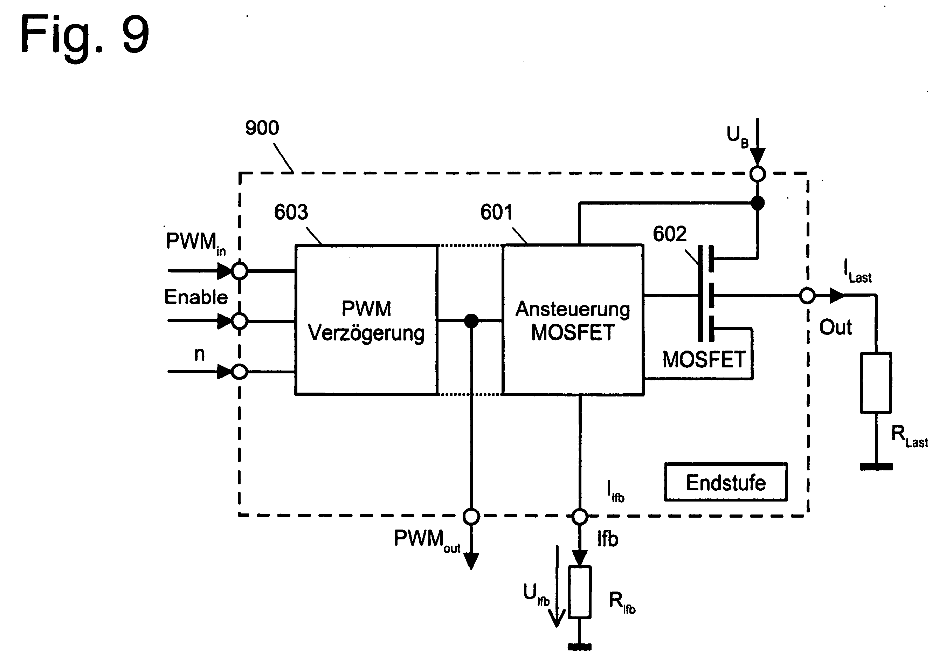

Figur 9 zeigt den Aufbau einer Endstufe gemäß einer alternativen Ausführungsform der vorliegenden Erfindung. Die Endstufe aus Fig. 9 unterscheidet sich nur insofern von der Endstufe aus Fig. 6A, als die Ansteuerungsschaltung 601 durch das verzögerte PWM-Signal $PWM_{out}$ getrieben wird und nicht durch das PWM-Eingangssignal $PWM_{in}$. Ansonsten haben die in den Figuren 6A und 9 mit den gleichen Bezugzeichen bezeichneten Elemente die gleiche Funktion, auf deren erneute detaillierte Beschreibung hier verzichtet werden kann.

Zusammenfassend kann festgestellt werden, dass zur Ansteuerung einer mehrstufigen Last mit Pulsweitenmodulation (PWM) üblicherweise die einzelnen Stufen getrennt mit jeweils phasenversetzt getakteten Lastströmen beaufschlagt werden, um Lastspitzen zu vermeiden. Herkömmliche Steuereinheiten zur phasenversetzten PWM-Ansteuerung zeichnen sich durch hohe Komplexität und/oder Probleme mit der zeitlichen Präzision der Taktung der einzelnen Lastströme aus. Es ist daher der besondere Ansatz der vorliegenden Erfindung, eine Endstufe zur PWM-Ansteuerung einer Laststufe mit einer Verzögerungsschaltung zu versehen, die zusätzlich zu dem durch ein PWM-Eingangssignal modulierten Laststrom ein PWM-Ausgangssignal liefert, das gegenüber dem PWM-Eingangssignal um einen vorgegebenen Bruchteil der Periodendauer verzögert ist. Insbesondere kann die erfindungsgemäße Endstufe realisiert werden, indem die Verzögerungsschaltung zusammen mit dem eigentlichen Leistungshalbleiterschalter und einer zugehörigen Überwachungs- und Ansteuerschaltung in einem einzigen Baustein integriert wird. Durch eine Kaskadierung derartiger Endstufen kann auf einfache Weise eine Steuereinheit zur phasenversetzten PWM-Ansteuerung realisiert werden, die unabhängig ist von einer genauen Zeitbasis.

**Patentansprüche**

1. Endstufe zur pulsweitenmodulierten Ansteuerung einer elektrischen Last, wobei die Endstufe umfasst:

   einen ersten Eingang (610) zur Eingabe eines ersten Pulsweitenmodulationssignals,
   einen Leistungshalbleiterschalter (602) zur Ansteuerung der elektrischen Last gemäß dem Tastverhältnis des ersten Pulsweitenmodulationssignals,
   eine Verzögerungsschaltung (603) zur Erzeugung eines zweiten Pulsweitenmodulationssignals, das gegenüber dem ersten Pulsweitenmodulationssignal verzögert ist, und
   einen Signalausgang (613) zur Ausgabe des zweiten Pulsweitenmodulationssignals,
   **dadurch gekennzeichnet, dass**
   die Verzögerungsschaltung (603) eine erste Detektorschaltung umfasst, die die Periodendauer des ersten Pulsweitenmodulationssignals ermittelt, und das zweite Pulsweitenmodulationssignal so erzeugt, dass es gegenüber dem ersten Pulsweitenmodulationssignal um einen durch ein Steuersignal (n) bestimmten Bruchteil der ermittelten Periodendauer verzögert ist.

2. Endstufe nach Anspruch 1, wobei der durch das Steuersignal (n) bestimmte Bruchteil der Periodendauer durch einen Stammbruch darstellbar ist.

3. Endstufe nach Anspruch 1 oder 2 mit einem zweiten Eingang (612) zur Eingabe des Steuersignals (n).

4. Endstufe nach einem der Ansprüche 1 bis 3, wobei der erste Detektor so eingerichtet ist, dass die Periodendauer während einer Periode des ersten Pulsweitenmodulationssignals ermittelt wird.

5. Endstufe nach einem der Ansprüche 1 bis 4, wobei die Verzögerungsschaltung (603) eine zweite Detektorschaltung umfasst, der die Einschaltdauer des ersten Pulsweitenmodulationssignals ermittelt, und das zweite Pulsweitenmodulationssignal so erzeugt, dass es die ermittelte Einschaltdauer aufweist.

6. Endstufe nach Anspruch 5, wobei der zweite Detektor so eingerichtet ist, dass die Einschaltdauer während einer Periode des ersten Pulsweitenmodulationssignals ermittelt wird.

7. Endstufe nach einem der Ansprüche 1 bis 6, wobei der Leistungshalbleiterschalter (602) ein MOSFET ist.

8. Endstufe nach einem der Ansprüche 1 bis 7, wobei der Leistungshalbleiterschalter (602) und die Verzögerungsschaltung (603) monolithisch auf einem Halbleiterchip integriert sind.

9. Endstufe nach einem der Ansprüche 1 bis 7, wobei der Leistungshalbleiterschalter (602) und die Verzögerungsschaltung (603) auf zwei getrennten Halbleiterchips realisiert sind, die in einem gemeinsamen Gehäuse integriert sind.

10. Endstufe nach einem der Ansprüche 1 bis 9 mit einer Zusatzschaltung (601) zur Ansteuerung des Leistungshalbleiterschalters (602).

11. Endstufe nach Anspruch 10, wobei die Zusatzschaltung (601) außerdem eine Schaltung zum Schutz des Leistungshalbleiterschalters (602) vor Überlastung umfasst.

12. Endstufe nach Ansprüche 10 oder 11, wobei die Verzögerungsschaltung (603) und die Zusatzschaltung (601) auf einem gemeinsamen Halbleiterchip integriert sind.

13. Steuereinheit zur pulsweitenmodulierten Ansteuerung einer elektrischen Last mit einer Mehrzahl elektrisch unabhängiger Laststufen, wobei die Steuereinheit umfasst:

eine erste Endstufe (710-1) nach einem der Ansprüche 1 bis 12 zur Ansteuerung einer ersten Laststufe der elektrischen Last gemäß einem vorgegebenen ersten Pulsweitenmodulationssignal und zur Ausgabe eines gegenüber dem ersten Pulsweitenmodulationssignal verzögerten zweiten Pulsweitenmodulationssignals; und eine zweite Endstufe (710-n) zur Ansteuerung einer zweiten Laststufe der elektrischen Last gemäß dem zweiten Pulsweitenmodulationssignal.

14. Steuereinheit nach Anspruch 13, wobei die zweite Endstufe (710-n) eine Endstufe nach einem der Ansprüche 1 bis 12 ist.

15. Steuereinheit nach Anspruch 13 oder 14, wobei die erste und die zweite Endstufe (710-1, 710-n) zu einer Mehrzahl kaskadiert verschalteter Endstufen nach einem der Ansprüche 1 bis 12 gehören, die jeweils einer Laststufe der elektrischen Last zugeordnet sind.

16. Steuereinheit nach Anspruch 15, wobei jede der kaskadiert verschalteten Endstufen ein Pulsweitenmodulationssignal ausgibt, das gegenüber dem eingegebenen Pulsweitenmodulationssignal um einen Bruchteil der Periodendauer verschoben ist, der der Anzahl der Laststufen der elektrischen Last entspricht.

17. Verfahren zur pulsweitenmodulierten Ansteuerung einer elektrischen Last mit einer Mehrzahl elektrisch unabhängiger Stufen mit den Schritten
Kaskadieren einer Mehrzahl von Endstufen nach einem der Ansprüche 1 bis 12, wobei jede Endstufe eine Stufe der elektrischen Last ansteuert;
Erzeugen eines Pulsweitenmodulationssignals; und
Einspeisen des Pulsweitenmodulationssignals an der ersten Endstufe der kaskadierten Mehrzahl von Endstufen.

18. Verfahren nach Anspruch 17, wobei beim Kaskadieren der Mehrzahl von Endstufen der Signalausgang (613) einer Endstufe mit dem ersten Eingang (610) einer nachfolgenden Endstufe verbunden wird.

19. Verfahren nach Anspruch 17 oder 18 mit dem zusätzlichen Schritt:

Einspeisen eines Steuersignals, das die Anzahl der Stufen der elektrischen Last angibt, an jeder Endstufe.

## Claims

1. An output stage for pulsewidth-modulated control of an electric load, said output stage comprising:

a first input (610) for inputting a first pulsewidth modulation signal;
a power semiconductor switch (602) for driving the electric load according to the duty cycle of the first pulsewidth modulation signal;
a delay circuit (603) for generating a second pulsewidth modulation signal which is delayed relative to the first pulsewidth modulation signal; and
a signal output (613) for outputting the second pulsewidth modulation signal,
**characterized in that**
the delay circuit (603) comprises a first detector circuit which detects the period duration of the first pulsewidth modulation signal and which generates the second pulsewidth modulation signal such that it is delayed relative to the first pulsewidth modulation signal by a fraction of the detected period duration, the fraction being determined by a control signal (n).

2. An output stage according to claim 1, wherein the fraction determined by the control signal (n) of the period duration can be represented by a unit fraction.

3. An output stage according to claim 1 or 2, further comprising a second input (612) for inputting the control signal (n).

4. An output stage according to any of claims 1 to 3, wherein the first detector is configured such that the period duration is detected during one period of the first pulsewidth modulation signal.

5. An output stage according to any of claims 1 to 4, wherein the delay circuit (603) comprises a second detector circuit which detects the on-time of the first pulsewidth modulation signal and which generates the second pulsewidth modulation signal such that the second pulsewidth modulation signal has the detected on-time.

6. An output stage according to claim 5, wherein the second detector is configured such that the on-time is detected during one period of the first pulsewidth modulation signal.

7. An output stage according to any of claims 1 to 6, wherein the power semiconductor switch (602) is a MOSFET.

8. An output stage according to any of claims 1 to 7, wherein the power semiconductor switch (602) and the delay circuit (603) are monolithically integrated on a semiconductor chip.

9. An output stage according to any of claims 1 to 8, wherein the power semiconductor switch (602) and the delay circuit (603) are realized on two separate semiconductor chips which are integrated in a common housing.

10. An output stage according to any of claims 1 to 9, further comprising an additional circuit (601) for controlling the power semiconductor switch (602).

11. An output stage according to claim 10, wherein the additional circuit further comprises a circuit for protecting the power semiconductor switch against overload.

12. An output stage according to claim 10, wherein the delay circuit (603) and the additional circuit (601) are integrated on a common semiconductor chip.

13. A controller for pulsewidth-modulated control of an electric load comprising a plurality of electrically independent load stages, wherein said controller comprises:

a first output stage (710-1) according to any of claims 1 to 12 for controlling a first load stage of the electric load in accordance with a predetermined first pulsewidth modulation signal and for outputting a second pulsewidth modulation signal which is delayed relative to said first pulsewidth modulation signal; and
a second output stage (710-n) for controlling a second load stage of the electric load in accordance with the second pulsewidth modulation signal.

14. A controller according to claim 13, wherein the second output stage (710-n) is an output stage according to any of claims 1 to 12.

15. A controller according to claim 13 or 14, wherein the first and the second output stages (710-1, 710-n) belong to a plurality of output stages according to any of claims 1 to 12 which are interconnected in a cascaded fashion and which are each associated with a load stage of the electric load.

16. A controller according to claim 15, wherein each of the cascaded output stages outputs a pulsewidth modulation signal which, in comparison with the inputted pulsewidth modulation signal, is shifted by a fraction of the period duration that corresponds to the number of load stages of the electric load.

17. A method for pulsewidth-modulated controlling of an electric load with a plurality of electrically independent stages, said method comprising:

cascading a plurality of output stages according to any of claims 1 to 12, each of said output stages controlling a stage of the electric load; generating a pulsewidth modulation signal; and feeding the pulsewidth modulation signal at the first output stage of the cascaded plurality of output stages.

18. A method according to claim 17, wherein, during cascading of the plurality of output stages, the signal output (613) of an output stage is connected to the first input (610) of the next output stage.

19. A method according to claim 17 or 18, further comprising feeding, at each output stage, a control signal which is indicative of the number of stages of the electric load.

**Revendications**

1. Étage final de commande en modulation de largeur d'impulsion d'une charge électrique, dans lequel l'étage final comprend :

une première entrée (610) pour introduire un premier signal de modulation par largeur d'impulsion,
un disjoncteur de puissance à semi-conducteur (602) pour la commande de la puissance électrique consommée selon le rapport cyclique du premier signal de modulation par largeur d'impulsion,
un circuit de retard (603) pour produire un deuxième signal de modulation par largeur d'impulsion retardé par rapport au premier signal de modulation par largeur d'impulsion, et une sortie de signal (613) pour sortir le deuxième signal de modulation par largeur d'impulsion,
**caractérisé**
**en ce que** le circuit de retard (603) comporte un premier circuit détecteur qui fournit la durée de période du premier signal de modulation par largeur d'impulsion, et qui produit le deuxième signal de modulation par largeur d'impulsion de telle sorte qu'il est retardé par rapport au premier signal de modulation par largeur d'impulsion d'une fraction déterminée de la durée de période obtenue par un signal de commande (n).

2. Étage final selon la revendication 1, dans lequel la fraction de la durée de période déterminée par le signal de commande (n) peut être représentée par une fraction unitaire.

**3.** Étage final selon la revendication 1 ou 2, avec une deuxième entrée (612) pour l'introduction du signal de commande (n).

**4.** Étage final selon l'une des revendications 1 à 3, dans lequel le premier détecteur est agencé de telle sorte que la durée de période est fournie à l'aide d'une période du premier signal de modulation par largeur d'impulsion.

**5.** Étage final selon l'une des revendications 1 à 4, dans lequel le circuit de retard (603) comporte un deuxième circuit détecteur qui fournit la durée cyclique de service continu du premier signal de modulation par largeur d'impulsion, et qui génère le deuxième signal de modulation par largeur d'impulsion de telle sorte qu'il fournit la durée cyclique de service continu.

**6.** Étage final selon la revendication 5, dans lequel le deuxième détecteur est agencé de telle sorte que la durée cyclique de service continu est fournie à l'aide d'une période du premier signal de modulation par largeur d'impulsion.

**7.** Étage final selon l'une des revendications 1 à 6, dans lequel le disjoncteur de puissance à semi-conducteur (602) est un transistor MOSFET.

**8.** Étage final selon l'une des revendications 1 à 7, dans lequel le disjoncteur de puissance à semi-conducteur (602) et le circuit de retard (603) sont intégrés d'une seule pièce dans un circuit intégré à semi-conducteur.

**9.** Étage final selon l'une des revendications 1 à 7, dans lequel le disjoncteur de puissance à semi-conducteur (602) et le circuit de retard (603) sont réalisés sur deux circuits intégrés semi-conducteurs séparés, qui sont intégrés dans un boîtier commun.

**10.** Étage final selon l'une des revendications 1 à 9, avec un circuit auxiliaire (601) de commande du disjoncteur de puissance à semi-conducteur (602).

**11.** Étage final selon la revendication 10, dans lequel le circuit auxiliaire (601) comporte en outre un circuit de protection du disjoncteur de puissance à semi-conducteur (602) contre une surcharge.

**12.** Étage final selon la revendication 10 ou 11, dans lequel le circuit de retard (603) et le circuit auxiliaire (601) sont intégrés sur un circuit intégré à semi-conducteur commun.

**13.** Unité de commande pour la commande par modulation de largeur d'impulsion d'une charge électrique avec une pluralité d'étages de charge électrique indépendants, dans lequel l'unité de commande comprend :

un premier étage final (710-1) selon l'une des revendications 1 à 12 pour la commande d'un premier étage de charge de la charge électrique en fonction d'un premier signal de modulation par largeur d'impulsion prédéterminé, et pour la sortie d'un deuxième signal de modulation par largeur d'impulsion retardé par rapport au premier signal de modulation par largeur d'impulsion ; et
un deuxième étage final (710-n) pour commander un deuxième étage de charge de la charge électrique en fonction du deuxième signal de modulation par largeur d'impulsion.

**14.** Unité de commande selon la revendication 13, dans lequel le deuxième étage final (710-n) est un étage final selon l'une des revendications 1 à 12.

**15.** Unité de commande selon la revendication 13 ou 14, dans lequel les premier et deuxième étages finaux (710-1, 710-n) appartiennent à une pluralité d'étages finaux connectés en cascade selon l'une des revendications 1 à 12, qui correspondent chacun à un étage de charge de la charge électrique.

**16.** Unité de commande selon la revendication 15, dans lequel chacun des étages finaux connectés en cascade sort un signal de modulation par largeur d'impulsion qui est décalé par rapport au signal de modulation par largeur d'impulsion introduit d'une fraction de la durée de période correspondant au nombre d'étages de charge de la charge électrique.

**17.** Procédé de commande par modulation de largeur d'impulsion d'une charge électrique avec une pluralité d'étages électriques indépendants, comportant les étapes consistant à
mettre en cascade une pluralité d'étages finaux selon l'une des revendications 1 à 12, dans lequel chaque étage final commande un étage de la charge électrique ;
produire un signal de modulation par largeur d'impulsion ; et
alimenter le signal de modulation par largeur d'impulsion au premier étage final de la pluralité d'étages finaux.

**18.** Procédé selon la revendication 17, dans lequel, lors de la mise en cascade de la pluralité d'étages finaux de la sortie de signal (613), un étage final est connecté à la première entrée (610) d'un étage final suivant.

**19.** Procédé selon la revendication 17 ou 18, comportant l'étape additionnelle consistant à :

alimenter à chaque étage final un signal de commande qui fournit le nombre d'étages de la charge électrique.

Fig. 1

# Fig. 2

EP 1 986 322 B1

# Fig. 3

# Fig. 4

EP 1 986 322 B1

Fig. 5

# Fig. 6A

# Fig. 6B

# Fig. 7

EP 1 986 322 B1

Fig. 8

# Fig. 9

EP 1 986 322 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2000050422 A
- EP 1157869 B1